(19) **Europäisches Patentamt**
**European Patent Office**
**Office européen des brevets**

(11) **EP 2 347 993 B1**

(12) **EUROPEAN PATENT SPECIFICATION**

(45) Date of publication and mention
of the grant of the patent:
**14.11.2018  Bulletin 2018/46**

(51) Int Cl.:
***B81C 1/00*** (2006.01)

(21) Application number: **11151337.0**

(22) Date of filing: **19.01.2011**

(54) **Method for manufacturing a micromachined device and micromachined device made thereof**

Verfahren zur Herstellung einer mikrogefertigten Vorrichtung und damit mikrogefertigte Vorrichtung

Procédé pour la fabrication d'un dispositif micro-usiné et dispositif micro-usiné correspondant

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.01.2010  US 297392 P**

(43) Date of publication of application:
**27.07.2011  Bulletin 2011/30**

(73) Proprietors:
 • **IMEC VZW**
   **3001 Leuven (BE)**
 • **Katholieke Universiteit Leuven**
   **K.U. Leuven R&D**
   **3000 Leuven (BE)**
 • **American University Cairo**
   **11511 Cairo (EG)**

(72) Inventors:
 • **El Rifai, Joumana**
   **11511 Cairo (EG)**
 • **Witvrouw, Ann**
   **3020, Herent (BE)**
 • **Abdel Aziz, Ahmed Kamal Said**
   **11571 Cairo (EG)**
 • **Sedky, Sherif**
   **Sheikh Zaid City (EG)**

(74) Representative: **Hertoghe, Kris Angèle Louisa et al**
   **DenK iP bvba**
   **Hundelgemsesteenweg 1116**
   **9820 Merelbeke (BE)**

(56) References cited:
   **EP-A2- 1 801 067     US-A1- 2007 278 600**

 • **BUSCHBECK J ET AL: "Thermodynamics and kinetics during pulsed laser annealing and patterning of FePt films", JOURNAL OF APPLIED PHYSICS, AMERICAN INSTITUTE OF PHYSICS. NEW YORK, US, vol. 100, no. 12, 19 December 2006 (2006-12-19), pages 123901-123901, XP012089308, ISSN: 0021-8979, DOI: 10.1063/1.2397294**

**Description**

**Field of the invention**

The present invention relates to methods for manufacturing micromachined devices and in particular methods for manufacturing structural silicon germanium layers having contact regions with low electrical resistivity, e.g. having an electrical resistivity value of 3.4 mΩ.cm or below, and low strain gradient suspended regions, e.g. having a strain gradient value or 6.8x10$^{-6}$ $\mu$m$^{-1}$ or below, suitable for the formation of micromachined devices.

**Background of the invention**

In the past years, the need for integrating Micro Electro Mechanical Systems (MEMS) (or also referred to as micromachined devices) with prefabricated Complementary Metal Oxide Semiconductor (CMOS) electronics to produce compact and improved devices has set some limitations on the processing temperature of the active MEMS material. Post-processing monolithic integration has forced a reduction in the maximum processing temperature to range from 420 to 520°C.

Polycrystalline silicon germanium is an attractive material for MEMS post-processing, allowing good electrical, mechanical and thermal properties at temperatures that are lower than the temperatures required for polycrystalline silicon processing.

Emerging interest in fabricating (MEMS) on temperature sensitive substrates, such as passive and flexible substrates, is further restricting the processing temperature of the active or structural layers. Using substrate materials such as benzocyclobutene (BCB), silicone, polymide (PI) or polyethylene terephthalate (PET) limits the maximum processing temperature to 300°C or lower.

There is thus a continuous need for further reduction of the processing temperature of polycrystalline silicon germanium structural layers.

In EP 1 801 067 A2, a method for manufacturing structural silicon germanium layers for surface machined MEMS devices at temperatures substantially below 400 degrees Celsius is disclosed. The method comprises deposition of amorphous silicon germanium (a-SiGe) at a temperature below 400 degrees Celsius using plasma enhanced chemical vapor deposition (PECVD). Such as-deposited a-SiGe has degraded electrical and mechanical properties, more specifically high stress, strain gradient and electrical resistivity, all of which are not acceptable for functional and reliable MEMS structural layers. The method further comprises a laser annealing step with restricted laser fluences for improving the mechanical properties (stress and/or strain) of as-deposited a-SiGe. By using the restricted laser fluences, a low strain gradient can be achieved. However, the structural layers thus obtained have high sheet resistance. It is suggested that by further tuning of the parameters of the as-deposited a-SiGe (for example increasing the germanium (Ge) content) and by using a higher number of laser pulses a lower resistitivity may be achieved. However a high Ge content is not fully compatible with standard CMOS processing. Moreover a high Ge content may affect device reliability.

**Aim of the invention**

It is an objective of embodiments of the present invention to overcome the disadvantages related to the prior art. It is an objective of embodiments of the present invention to provide a method for manufacturing a micromachined device (MEMS device) at temperatures below 400 degrees Celsius, independent of the driving electronics fabrication process and the substrate type used. More specifically embodiments of the present invention provide a method for forming an optimized structural layer with optimized electrical properties (low resistivity, e.g. below 3.4 mΩ.cm) for one part of the structural layer and optimized mechanical properties (low strain gradient, e.g. below 6.8x10$^{-6}$ $\mu$m$^{-1}$) for another part of the structural layer. Embodiments of the present invention provide a method for forming an optimized structural layer with a predetermined strain gradient for one part of the structural layer and a predetermined resistivity for another part of the structural layer.

**Summary of the invention**

The above objectives are accomplished by a method and device according to embodiments of the present invention.

Particular and preferred aspects of the invention are set out in the accompanying independent and dependent claims.

According to embodiments of the present invention, a method for manufacturing a micromachined device is disclosed, the method comprising:

- providing a structural layer of amorphous semiconductor material, the structural layer having an initial resistivity and an initial strain gradient;
- defining a first region and a second region in the structural layer;
- providing a shielding layer above the first region, thereby leaving the second region unshielded;
- thereafter laser annealing the second region of the structural layer with a first fluence, wherein the layer annealing with the first fluence decreases the resistivity in the second region from the initial resistivity to a predetermined resistivity,the first fluence being in the range of 600mJ/cm$^2$ to 1000mJ/cm$^2$;
- thereafter removing the shielding layer;
- thereafter annealing the first and the second region of the structural layer with a second fluence, the second fluence being substantially smaller than the first fluence; the second fluence for example being not larger than half of the first fluence, for example the second fluence being between 10% and 30% of the first fluence,wherein the laser annealing with the second fluence decreases the strain gradient in the first region from the initial strain gradient to a predetermined strain gradient.

According to embodiments of the present invention, a method for manufacturing a micromachined device is disclosed.

It is an advantage of embodiments of the present invention that an optimized structural layer for micromachined applications may be formed.

It is an advantage of embodiments of the present invention that both electrical (low resistivity) and/or mechanical properties (low strain gradient, strain gradient being defined as the positive difference in the strain between top and bottom of a cantilever of a micromachined device divided by its thickness) are optimized for a structural layer for micromachined applications.

According to embodiments of the present invention, converting at least part of the amorphous semiconductor material in the second region may comprise converting completely the amorphous semiconductor material in the second region.

According to embodiments of the present invention, annealing the first and the second region of the structural layer with a second fluence comprises annealing thereby converting at least part of the amorphous semiconductor material in the first region. At least part of the amorphous semiconductor material in the first region may comprise at least the upper part of the amorphous semiconductor material in the first region.

According to embodiments converting the amorphous semiconductor material comprises converting the amorphous semiconductor material into crystalline semiconductor material. The amorphous semiconductor material may for example be amorphous silicon germanium.

According to embodiments at least part of the amorphous semiconductor layer or the complete amorphous semiconductor layer is converted into crystalline semiconductor material.

According to embodiments the step of providing a structural layer of amorphous semiconductor material may be performed by means of a plasma enhanced chemical vapor deposition (PECVD) process. Providing the structural layer of amorphous semiconductor material may be performed at a temperature below 400 degrees Celsius.

According to embodiments defining a first region and a second region in the structural layer may comprise defining a contact region and a suspended region in the structural layer.

According to embodiments the shielding layer comprises a reflective material. The reflective material may for example be aluminum.

It is an advantage of embodiments of the present invention that no drastic changes are detected in the shielded region (first region) after the first annealing step.

According to embodiments the -first number of laser pulses may be in the range between 1 and 1000, for example between 1 and 500. In embodiments of the present invention, the number of laser pulses may be selected so as to decrease the crystallization depth to tune the strain gradient. The first pulse repetition rate may be in the range between 1 Hz and 50 Hz. In embodiments of the present invention, the pulse repetition rate may be selected so as to decrease the crystallization depth to tune the strain gradient. Advantageously the first annealing step comprises one pulse (and not pulse repetition rate) with a fluence between 600-1000 mJ/cm$^2$.

According to embodiments the second fluence may be smaller than 250mJ/cm$^2$.

According to another embodiment of the present invention a semiconductor device is disclosed, the semiconductor device comprising a SiGe-layer, the SiGe-layer comprising a first region with a predetermined strain gradient and a second region with a predetermined resistivity. The semiconductor device may be a MEMS device.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

**Brief description of the figures**

FIG. 1 to FIG. 5 shows a schematic flow diagram according to different steps from a method according to an embodiment of the present invention.

FIG. 6 shows a schematic representation of different parts of a structural layer for a micromachined device.

FIG. 7 shows a secondary electron microscopy (SEM) image of released cantilevers according to an embodiment of the present invention.

FIG. 8 shows a secondary electron microscopy (SEM) image of released cantilevers according to an embodiment of the present invention.

FIG. 9 shows a transmission electron microscopy (TEM) image of a stack of layers with poly-SiGe after performing a thermal treatment according to embodiments of the present invention.

FIG. 10 shows a resistivity versus single pulse laser fluence plot for a thermal treatment according to an embodiment of the present invention.

FIG. 11 shows a transmission electron microscopy (TEM) image of a poly-SiGe layer after performing a thermal treatment according to an embodiment of the present invention.

FIG. 12 shows a transmission electron microscopy (TEM) image of a-SiGe layer after performing a thermal treatment according to an embodiment of the present invention.

FIG. 13 shows a schematic representation of a micromachined device according to different steps from a method according to an embodiment of the present invention.

FIG. 14 shows a secondary electron microscopy (SEM) image of released cantilevers according to an embodiment of the present invention.

FIG. 15 shows a secondary electron microscopy (SEM) image of released cantilevers according to an embodiment of the present invention.

**Description of illustrative embodiments**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention. Any reference signs in the claims shall not be construed as limiting the scope. In the different drawings, the same reference signs refer to the same or analogous elements.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Furthermore, while some embodiments described herein include some but not other features included in other embodiments, combinations of features of different embodiments are meant to be within the scope of the invention, and form different embodiments, as would be understood by those in the art.

The disclosure is related to method for manufacturing a micromachined device and will now be explained in more detail with reference to particular embodiments, the present invention not being limited thereto but only being limited by the claims.

According to embodiments of the present invention, a method for manufacturing a micromachined device is disclosed, the method comprising:

- providing a structural layer 101 of amorphous semiconductor material, the structural layer having an initial resistivity and an initial strain gradient;
- defining a first region 111 and a second region 112 in the structural layer 101;
- providing a shielding layer 104 above the first region 111, thereby leaving the second region 112 unshielded;
- thereafter laser annealing the second region 112 of the structural layer 101 with a first fluence,wherein the laser annealing with the first fluence decreases the resistivity in the second region from the initial resistivity to a predetermined resistivity,the first fluence being in the range of 600mJ/cm$^2$ to 1000 mJ/ cm$^2$;
- thereafter removing the shielding layer 104;
- thereafter laser annealing the first 111 and the second region 112 of the structural layer 101 with a second fluence, the second fluence being substantially smaller than the first fluence, wherein the laser annealing with the second fluence decreases the strain gradient in the first region from the initial strain gradient to a predetermined strain gradient.

The step of providing a structural layer of amorphous semiconductor material may be performed by means of a plasma enhanced chemical vapor deposition (PECVD) process. Providing the structural layer of amorphous semiconductor material may be performed at a temperature below 400 degrees Celsius.

Defining a first region 111 and a second 112 region in the structural layer 101 may comprise defining a contact region and a suspended region respectively in the structural layer. The suspended region defines the region where there is no contact with an underlying layer 103. The contact region defines the region of the structural layer 101 where the suspended region is anchored or connected to the underlying layer 103. In a MEMS device a flexible beam is an example of a structural layer. A MEMS beam is typically formed in a structural layer comprising a freestanding part of the beam and an anchor of the beam, where the flexible beam is connected to the underlying layer 103.

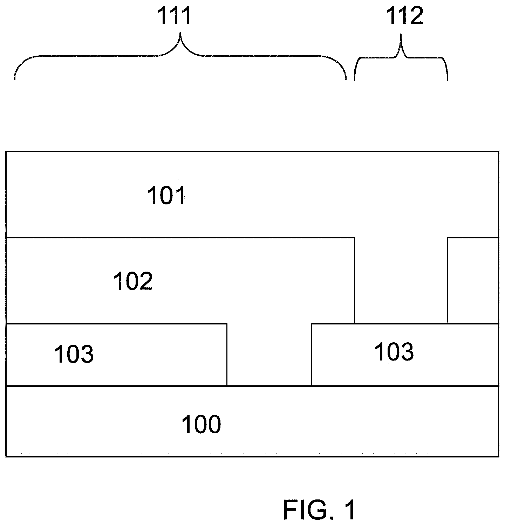

A structural layer for a MEMS device typically comprises at least one area with at least one suspended part and at least one contact area. The structural layer of the MEMS device may for example comprise a freestanding beam. The freestanding beam is attached at an anchor point to its underlying layer 103. The structural layer comprises thus an area with suspended parts (the freestanding beam) and a contact area (the anchor point of the freestanding beam). It is advantageous if the at least one area with suspended parts has a low strain gradient (strain gradient being defined as the positive difference in the strain between top and bottom of the suspended part divided by its thickness), e.g. a strain gradient below $6.8 \times 10^{-6}$ $\mu m^{-1}$, whereas the at least one contact area has low electrical resistivity, e.g. a resistivity below 3.4 m$\Omega$.cm. FIG. 1 shows a schematic overview of a stack of layers comprising a substrate layer 100, an underlying layer 103 on the substrate layer 100, a sacrificial layer 102 on the underlying layer 103 and a structural layer 101 on the sacrificial layer 102. After formation of the structure in the structural layer 101, the sacrificial layer 102 is typically removed, thereby forming a cavity in between a free-standing part of the structural layer 101 and the underlying layer 103.

The calculation of the strain gradient takes into account the deflection and dimension of the structure and is defined by equation (1):

$$\frac{2 \times deflection}{length^2} \qquad (1)$$

with deflection being the deflection from the tip of the cantilever compared to 0 horizontal and with length being the length of the cantilever.

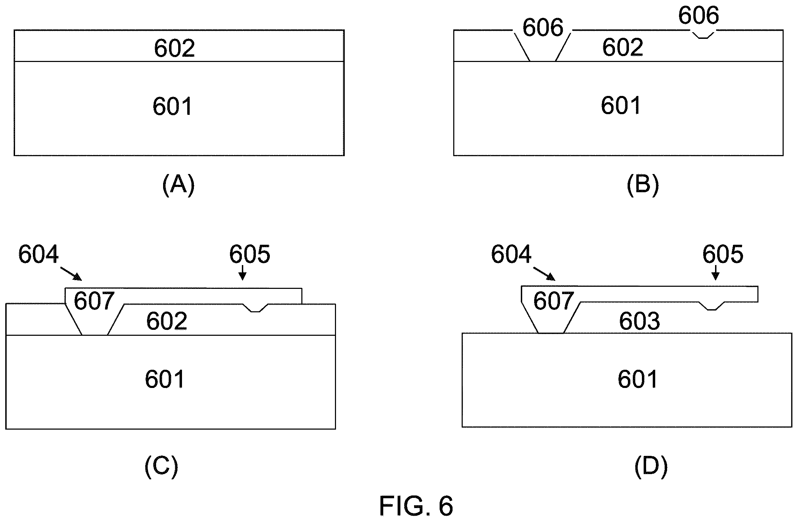

FIG. 6 shows the different parts of a structural layer for a MEMS device. A substrate layer 601 is used as support layer on which multiple alternating layers of structural and sacrificial material are deposited and patterned to realize micromechanical structures. A sacrificial layer 602 is formed on a substrate layer 601. The sacrificial layer 602 is patterned to create openings 606 to the underlying substrate layer 601. A structural layer 607 is deposited on the sacrificial layer 602 and patterned into the desired geometry, for example a freestanding beam. The sacrificial material 602 is removed and as such part 605 of the structural layer is released at a suspended region, whereas another part 604 of the structural layer remains connected to the underlying substrate layer 601 at the anchor or contact region.

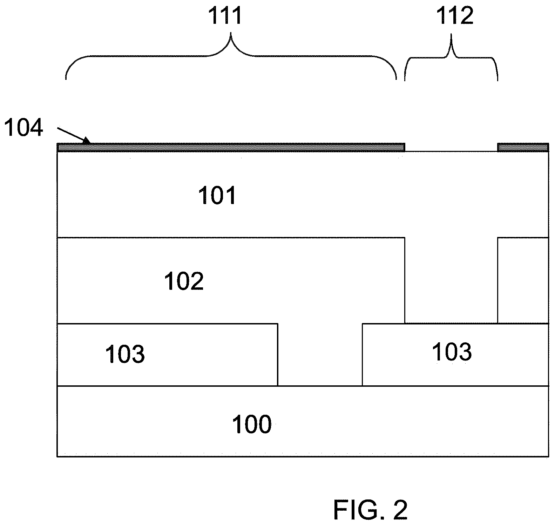

When returning back to the structure as illustrated in FIG. 1, a shielding layer 104 is provided on the first region 111, as illustrated in FIG. 2. The shielding layer 104 is not present on the second region 112. As long as the shielding layer 104 is present on the first region 111, any thermal treatment performed on the structural layer 101 will only affect the second region 112 and will substantially not affect the first region 111. The shielding layer 104 on the first region 111 is shielding the first region 111 during a first annealing step. The first region 111 is substantially not influenced by the first annealing step when the shielding layer 104 is present on the first region 111. More specifically the electrical properties and/or mechanical properties of the first region 111 are substantially not influenced by the first annealing step as long as the shielding layer 104 is present on the first region 111.

In embodiments of the present invention, the shielding layer 104 may comprise a material which can withstand high thermal fluences, such as e.g. fluences higher than 600mJ/cm$^2$, for example 6000 pulses at a laser fluence of 960 mJ/cm$^2$, without experiencing any drastic changes or deterioration.

In embodiments of the present invention, the shielding layer 104 may, alternatively or on top thereof, comprise a reflective material, for example aluminum. Aluminum can provide a 90% reflectance.

It is an advantage of embodiments of the present invention that no drastic changes are detected in the shielded region (first region 111) after the first annealing step.

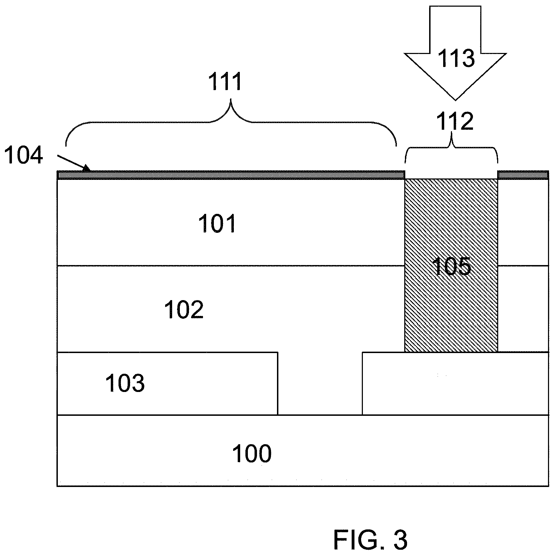

After providing the shielding layer 104, a first thermal treatment 113 is performed to the structural layer 101. As the first region 111 is protected by the shielding layer 104, only the second region 112 is affected by the first thermal treatment 113 (FIG. 3).

According to embodiments of the present invention annealing the second region 112 of the structural layer 101 with a first fluence may comprise thereby converting at least part of the amorphous semiconductor material in the second region 112 into crystalline material. The amorphous semiconductor material in the second region 112 may be converted partially or completely.

The first thermal treatment 113 comprises a first laser annealing step. The process parameters of the first annealing step may include a first laser pulse fluence, a first number of laser pulses and a first pulse repetition rate. The first annealing step may be characterized by a first fluence which is higher than 600 mJ/cm$^2$. The first fluence may be between 600-1000 mJ/cm$^2$. The first number of laser pulses is between 1 and 1000, for example between 1 and 500. The number of laser pulses may be selected so as to decrease the crystallization depth to tune the strain gradient. The first pulse repetition rate is between 1 Hz and 50 Hz. The pulse repetition rate may be selected so as to decrease the crystallization depth to tune the strain gradient. Advantageously the first annealing step comprises one pulse (and not pulse repetition rate) with a fluence between 600-1000 mJ/cm$^2$.

After the first laser annealing treatment 113 the amorphous semiconductor material of the second region 112 of the structural layer 101 may be converted, partially or completely, into crystalline semiconductor material 105. For example a-SiGe may be converted to poly-SiGe after applying a first annealing step. The amorphous semiconductor material of the second region 112 may advantageously be completely converted into crystalline semiconductor material. Such complete conversion of the amorphous semiconductor material of the second region 112 is advantageous as the electrical resistivity is lower with larger crystallization depth. The crystallization depth in the second region 112 may be equal or smaller than the thickness of the structural layer 101. The crystallization depth in the second region 112 may advantageously be equal to the thickness of the structural layer 101, as this results in the lowest resistivity. The thermal penetration depth is thus advantageously limited to the amorphous semiconductor layer of the second region 112.

After laser annealing the second region 112 with the first fluence, the initial resistivity of the second region 112 is reduced without substantially affecting the initial resistivity in the first region 111. With substantially is meant that the resistivity of the first region 111 after applying the first annealing step (and before applying a second annealing step) is less than 15 percent lower than the initial resistivity in the first region 111. The resistivity of the second region 112 after the first annealing step may be at least 99 percent lower than the initial resistivity thereof.

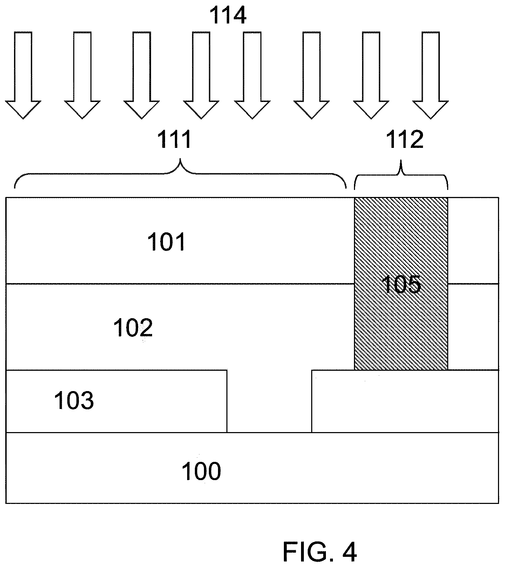

After the first annealing step the shielding layer 104 is removed (FIG. 4). Removing the shielding layer 104 may be done in any suitable way, for example by a chemical etching step.

After removing the shielding layer 104 a second thermal treatment 114 is applied to the structural layer 101 (FIG. 4). The second thermal treatment 114 may be a second annealing step, more specifically a second laser annealing step. The process parameters of the second annealing step may include a second laser pulse fluence, a second number of laser pulses and a second pulse repetition rate. The second fluence is smaller than the first fluence. The second fluence is advantageously at least 1.5 times smaller, for example at least 2 times smaller, such as for example at least 2.4 times smaller than the first fluence. Depending on the pulse rate, i.e. when multiple pulses are used, the second fluence may be at least 3 times, for example at least 4 times, such as at least 4.6 times smaller than the first fluence.

The second fluence may advantageously be smaller than 250mJ/cm$^2$, as this ensures a shallow crystallization depth enough to produce flat cantilevers.

The second number of laser pulses may be between 1 and 1000, or between 1 and 500. The first pulse repetition rate may be between 1 Hz and 50 Hz.

The second laser pulse fluence may be lower than 250 mJ/cm$^2$ for single pulse and advantageously lower than 130 mJ/cm$^2$ for multiple pulse.

The second laser pulse fluence may be between 230-250 mJ/cm$^2$ for single pulse and may be between 80-130 mJ/cm$^2$ for multiple pulse, for example for a number of pulses in the range from 100 to 1000 pulses. The second number of laser pulses may be between 1 and 1000, or between 1 and 500. If multiple pulses are applied, the second pulse repetition rate may be between 1 Hz and 50 Hz.

The second laser annealing step may be applied to both the first region 111 and the second region 112. As the second fluence is lower than the first fluence, for example at least 1.5 times smaller, for example at least 2 times smaller, such as for example at least 2.4 times smaller, the second region 112 is substantially not influenced by the second fluence. The resistivity of the second region 112 is substantially not changed after the second thermal treatment step 114. After annealing the first region 111 and the second region 112 with the second fluence the initial strain gradient is decreased in the first region 111. Nevertheless, despite the fact that the lower laser fluence of the second annealing step does not alter the previously crystallized 112 region, the second annealing step may be applied to only the first region 111. This would require a second shielding step (not illustrated in the drawings).

The initial strain gradient in the first region 111 may thus be decreased to a predetermined strain gradient. The parameters of the second annealing step (such as pulse fluence, pulse rate, number of pulses) may be chosen such that compressive stress from the deposited amorphous semiconductor layer 101 is reduced by the second annealing step. More particularly the initial strain, for example the initial compressive stress of the amorphous semiconductor layer 101, may be converted to a low tensile stress by the second annealing step.

The first thermal treatment 113 may be a harsh laser annealing step, whereas the second thermal treatment 114 may be a soft laser annealing step.

It is an advantage of embodiments of the present invention that both electrical (low resistivity) and mechanical properties (low strain gradient) are optimized for a structural layer for micromachined applications. The fact whether electrical properties (resistivity) or mechanical properties (strain gradient) are changed depend on the parameters of the fluencies. Laser annealing influences both electrical and mechanical parameters at the same time. In accordance with embodiments of the present invention, the first treatment is tuned to optimize electrical properties but if one would check mechanical properties, excessive tensile stress and strain gradient would be found. That is why a shielding layer, such as for example an aluminum shielding layer, may be used to protect suspended structures during the first laser annealing treatment. Hence the first laser treatment is applied only on locations where good electrical properties are desired, for example on anchored contacts. It is advantageous that such locations can withstand the excessive stress because they are not suspended.

In accordance with embodiments of the present invention, the second treatment is tuned to optimize mechanical properties because of its importance in suspended structures. If one would check the electrical properties, a resistivity would be found that is lower than that of amorphous semiconductor material, e.g. a-SiGe, but not as low as that in the second region 112. Laser fluence is proportional to the electrical resistivity.

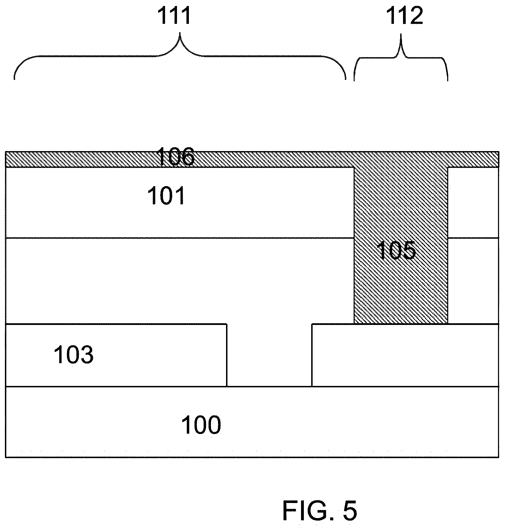

According to embodiments of the present invention, annealing 114 the first 111 and the second region 112 of the structural layer 101 with a second fluence comprises annealing thereby converting at least part of the amorphous semiconductor material in the first region 111. At least part of the amorphous semiconductor material in the first region 111 may comprise at least the upper part of the amorphous semiconductor material in the first region 111 (FIG. 5).

During the second thermal treatment 114 the upper part of the first region 111 of the structural layer 101 may be converted into crystalline semiconductor material 106. When amorphous SiGe is for example used for the structural layer 101, the a-SiGe may be converted into poly-SiGe in the second region 112 during the first thermal treatment and the a-SiGe from an upper part of the first region 111 may be converted into poly-SiGe in the first region 111. The crystallization depth in the first region may be about 200 nm or lower.

The first and the second annealing step may be performed using a pulsed excimer laser.

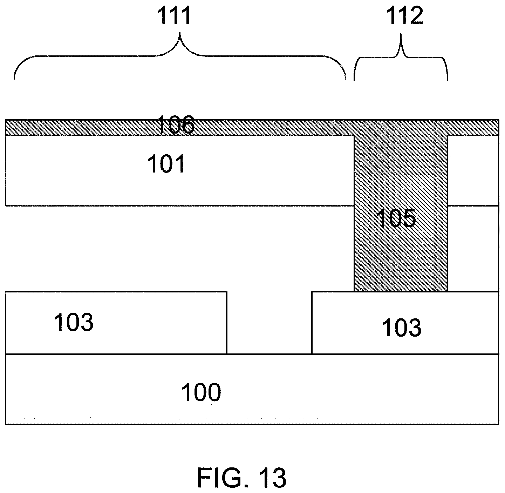

After performing the different steps according to embodiments of the present invention, the sacrificial layer 102 may be removed as such forming a free standing structural layer with first region 111 not in connection with the underlying layer 103 and an anchor point as such connecting the second region 112 of the structural layer 101 with the underlying layer 103 (FIG. 13).

Converting the amorphous semiconductor material may comprise converting the amorphous semiconductor material into crystalline semiconductor material. The amorphous semiconductor material may for example be amorphous silicon germanium. By annealing, for example by laser annealing, the amorphous silicon germanium (a-SiGe), the amorphous silicon germanium is converted into crystalline silicon germanium (poly-SiGe). Depending on the thickness of the amorphous semiconductor layer 101 and depending on the properties of the annealing step (i.e. for example fluence, number of pulses) at least part of the amorphous semiconductor layer or the complete amorphous semiconductor layer 101 may be converted into crystalline semiconductor material.

It is an advantage of embodiments of the present invention that a structural layer for micromachined applications may be formed which is optimized in terms of electrical and/or mechanical properties, e.g. resistivity and/or strain gradient.

After applying different process steps according to embodiments of the present invention, more specifically after applying the first and the second annealing step, the structural layer 101 may comprise one part 105 with a predetermined strain gradient and another part 106 with a predetermined resistivity. The predetermined strain gradient is lower than the initial strain gradient. The predetermined resistivity is lower than the initial resistivity.

To provide an optimized structural layer, i.e. with optimized electrical properties and optimized mechanical properties, a first and a second annealing step may be applied to the second (contact) region and a second annealing step may be applied to the first (suspended) region of the structural layer 101. After applying the first annealing step, the electrical properties for the second region 112 are optimized, whereas after applying the second annealing step the mechanical properties of the first region 111 are optimized.

After applying the first annealing step, the second region 112 is characterized by a predetermined resistivity being different from the initial resistivity. The predetermined resistivity may be smaller than the initial resistivity. After applying the second annealing step, the first region 111 is characterized by a predetermined strain gradient being different from the initial strain gradient. The predetermined strain gradient may be smaller than the initial strain gradient.

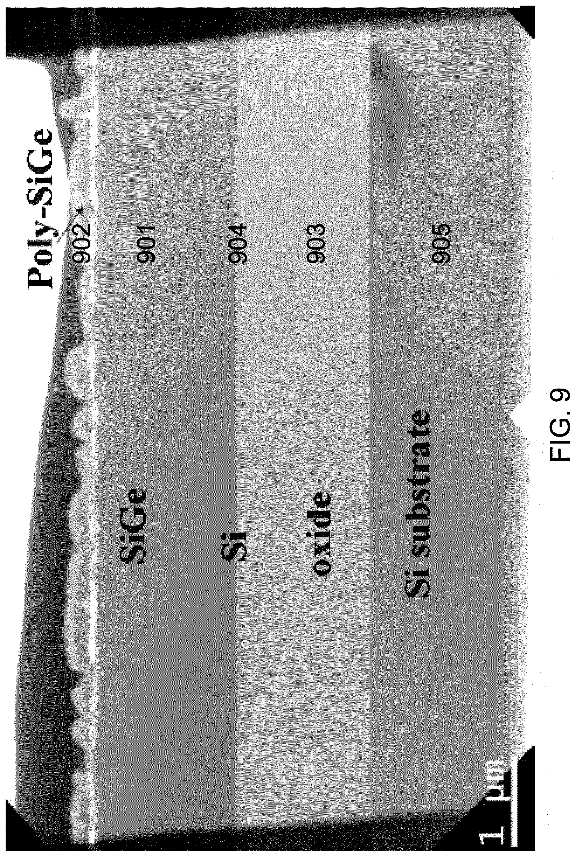

FIG. 9 shows experimental results for PECVD SiGe layers which were prepared at 210°C on Si wafers 905 covered with 2 $\mu$m $SiO_2$ 903. A 200 nm a-Si layer 904 was used in between the B-doped $Si_{72}Ge_{28}$ 901 and the 2 $\mu$m thick sacrificial oxide 903 for improved adhesion. For different experiments, the SiGe layers were 1.0, 1.6 and 1.8 $\mu$m thick. The electrical and mechanical properties of the as grown amorphous and laser annealed layers were determined as follows. The sheet resistance and surface roughness was measured on blanket samples using a four-point probe and Dektak surface profiler, respectively. The strain gradient was determined from the cantilever out of plane deflection.

Laser crystallization on blanket and patterned samples was performed using a KrF Excimer laser (248 nm) with a 23 mm$^2$ spot size and a 24 ns pulse duration. Blanket samples underwent a harsh laser treatment to increase the crystallization depth and reduce the resistivity of the layers, while the laser fluence was restricted to a maximum of 120 mJ/cm$^2$ for the strain gradient optimization in patterned samples. With harsh laser treatment is meant a laser treatment with a fluence higher than 600 mJ/cm$^2$ up to 1000 mJ/cm$^2$)

Additionally, patterned and blanket 1 $\mu$m Aluminum (Al) layers were used to investigate Al shielding properties under the harsh laser annealing (LA) conditions. The Al layers were deposited, by sputtering at room temperature, directly on a-SiGe. They were either patterned or left blanket and exposed to the laser beam. After treatment, surface roughness changes were monitored on the blanket Al layers to examine the layer's endurance to the harsh laser annealing conditions. For the patterned Al samples, the Al was removed after the laser treatment by a wet etch in diluted HF.

The underlying SiGe layer was then examined by SEM to detect visible changes between the exposed and unexposed SiGe. Additionally the sheet resistance and surface roughness were measured in both treated and untreated locations and compared to that of the as-grown a-SiGe and previously laser annealed poly-SiGe samples.

As-grown deposited layers were tuned to be highly compressive. The laser pulse shifted the stress to more tensile values, and layers with an initial high compressive stress had a higher limit for the maximum laser fluence. A low Ge concentration of 28% turned out to be more efficient in enduring harsh laser annealing conditions. Higher Ge concentrations lowered the material's melting point and therefore were more sensitive to slight variations in the laser pulse.

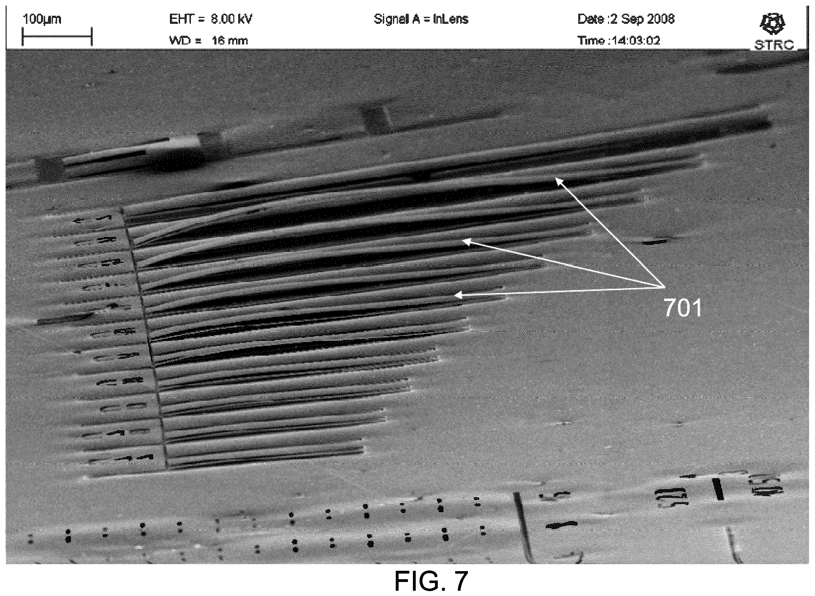

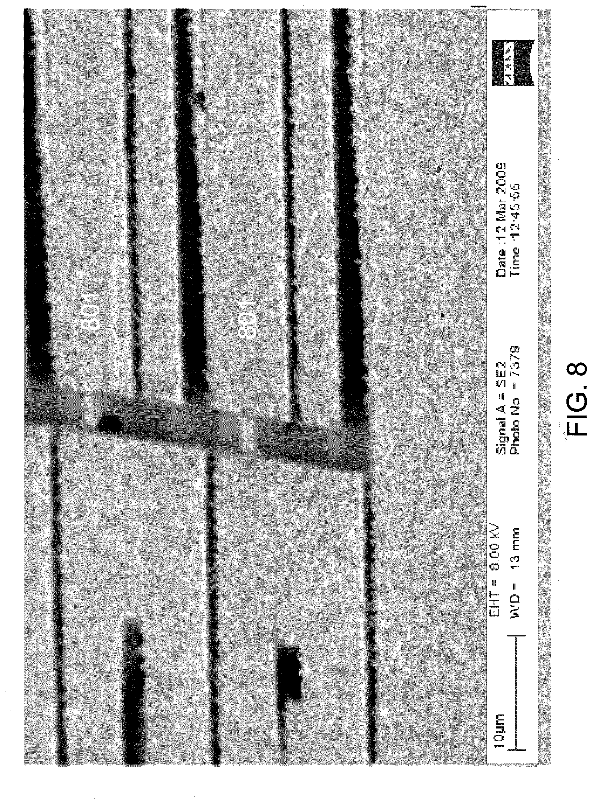

Films were initially amorphous with a minimum resistivity reading of $4.02 \times 10^3$ $\Omega \cdot$cm. The measured surface roughness of the as-grown layers ranged from 35.7 nm to 69.3 nm. As-grown layers had an initial strain gradient such that 0.65 mm long beams have an out of plane deflection between 8.9 and 18.3 $\mu$m with tips touching the substrate. FIG. 7 shows a secondary electron microscopy (SEM) image of released cantilevers 701 before the laser annealing treatment. Figure 8 shows a secondary electron microscopy (SEM) image of released cantilevers 801 after a laser annealing treatment with 500 pulses at 10 Hz and 120 mJ/cm$^2$ resulting in a reduced strain gradient.

Either a single or multiple pulse technique can be used to minimize the strain gradient. For a 1.8 $\mu$m thick $Si_{72}Ge_{28}$ film deposited at 210°C, 500 pulses at 10 Hz and 120 mJ/cm2 are sufficient to reduce the strain gradient to $-1.6 \times 10^{-7}$ $\mu$m$^{-1}$. However, a treatment at this laser fluence results in a moderate resistivity of 35.8 m$\Omega \cdot$cm. A limitation to ensure reduced strain gradient values is to keep the total supplied energy for a single pulse treatment below 240 mJ/cm$^2$. This will affect the maximum crystallization depth. Transmission electron microscopy (TEM) analysis shows that only a maximum crystallization depth of 0.2 $\mu$m is achieved for the 1.8 $\mu$m SiGe film annealed with 500 pulses at 10 Hz and 120 mJ/cm$^2$. FIG. 9 shows a TEM image for a multiple pulse treatment of 500 pulses at 10 Hz and 120 mJ/cm$^2$ applied to a 1.8 $\mu$m thick $Si_{72}Ge_{28}$ layer 901. After the laser treatment only upper part of the $Si_{72}Ge_{28}$ layer 901 is converted into polycrystalline SiGe (poly-SiGe) 902. A crystallization depth of only 0.2 $\mu$m is achieved.

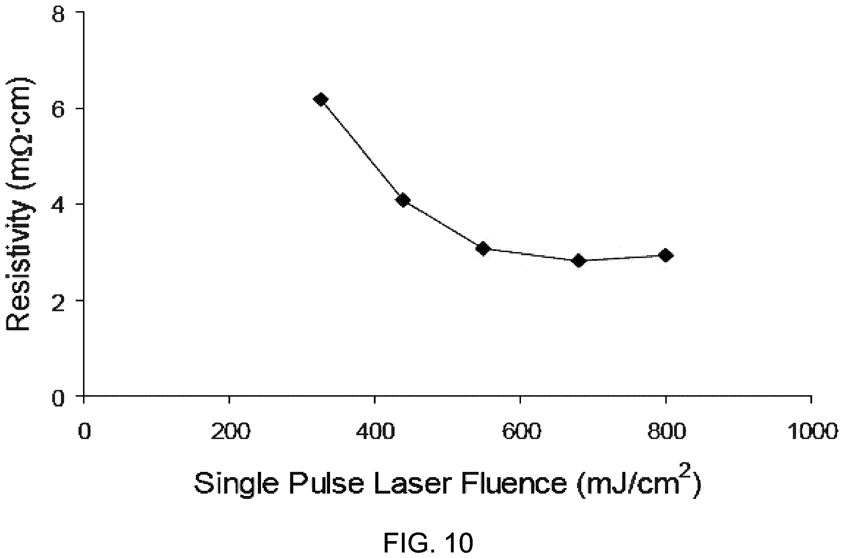

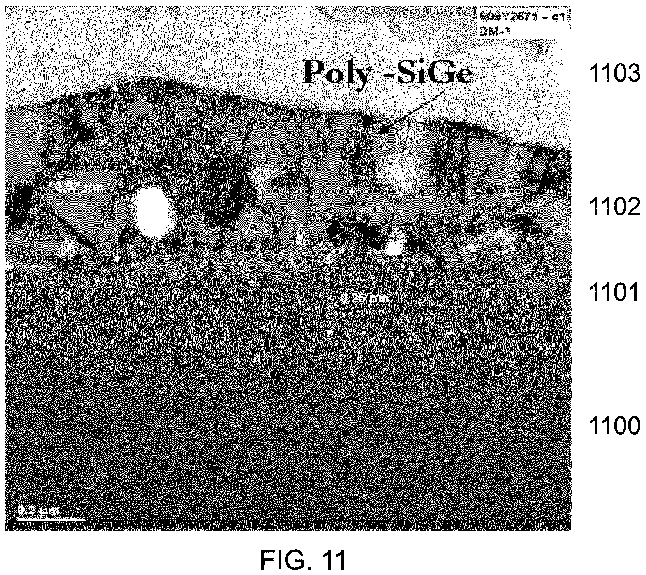

Increasing the laser fluence increases the crystallization depth and decreases the resistivity. FIG. 10 outlines the effect of a single pulse fluence on the resistivity of a $Si_{72}Ge_{28}$ sample. The resistivity is plotted in function of the single pulse fluence. As the energy supplied to the layer increases, the structural changes become deeper and more effective and the resistivity is reduced. A laser fluence of 680 mJ/cm$^2$ is sufficient to reduce the resistivity to a low value of 2.83 $\Omega$m$\cdot$cm with a surface roughness of 125.5 nm. The crystallization depth produced by such a treatment is 1 $\mu$m as seen in FIG. 11. FIG. 11 shows a TEM image of a poly-SiGe layer 1102 achieved after performing a laser treatment to a 1.6 $\mu$m thick $Si_{72}Ge_{28}$ layer with a single fluence pulse of 680 mJ/cm$^2$. A crystallization depth of approximately 0.6-1 $\mu$m is achieved. A variation in grain size is visible across the depth of the layer due to a temperature gradient during the laser annealing step. A layer of larger grains 1102, about 0.57 $\mu$m deep, is measured, as well as a layer of finer grains 1101, about 0.25 $\mu$m deep. The poly-SiGe layer is formed on a 200 nm a-Si layer (not clearly visible in FIG. 11, but as layer 904 in FIG. 9). The a-Si layer is formed on a 2 $\mu$m $SiO_2$ 1100. However, such a harsh laser treatment on suspended structures would result in an excessive strain gradient and would degrade the material's mechanical properties. FIG. 11 furthermore shows a CVD oxide layer 1103, which is added during TEM analysis to protect the sample during sample preparation.

For an optimized structural layer with both good electrical (low resistivity) (for the contact areas) and mechanical properties (low strain gradient) (for the suspended areas), higher laser fluences should be used on contacts to increase the crystallization depth and lower laser fluences should be applied in sections where the structures are suspended. This can be achieved by using a shielding material 104 that protects the suspended structures from the high fluence laser beam (FIG. 3).

The selection of such a protective layer 104 is challenging since this layer should withstand a high laser fluence without experiencing any drastic changes. Various trials to select an appropriate shielding material were conducted ($Si_3N_4$, thick photoresist, $SiO_2$ and Al), and Al presented the best results due to its high reflectivity. Aluminum can provide a 90% reflectance and even higher at 248 nm.

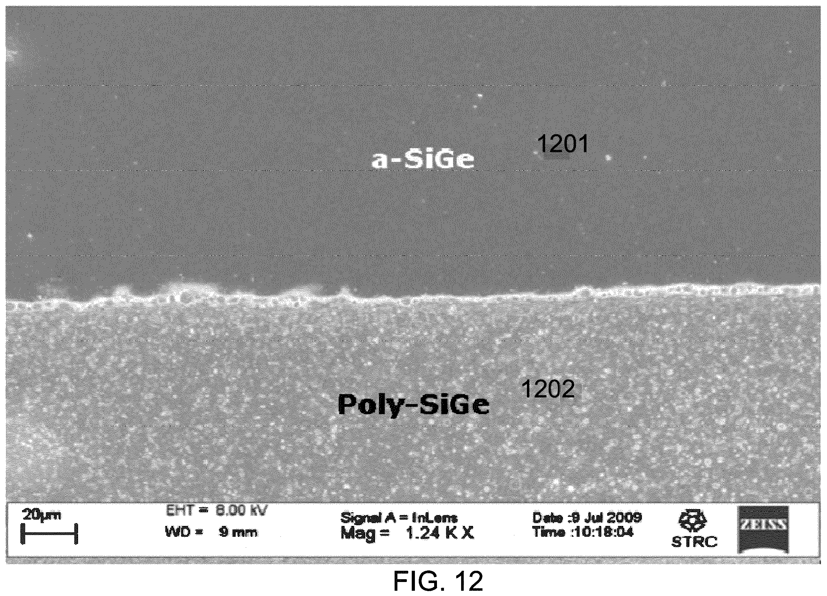

An amorphous 1.6 $\mu$m SiGe layer with initial resistivity of $4.0\pm0.9\times10^3$ $\Omega\cdot$cm and surface roughness of 69.3 nm was protected with a patterned 1 $\mu$m thick Al layer. The sample was exposed to a 680 mJ/cm$^2$ laser treatment. The Al shield was removed by a wet etch in diluted HF and the sample was examined. In the unshielded sections exposed to the laser beam, the layer's resistivity dropped to 3.47 m$\Omega\cdot$cm while in the shielded sections it remained at a high value of $3.4\times10^3$ $\Omega\cdot$cm. FIG. 12 displays a SEM image of an a-SiGe layer partly shielded and exposed to a high laser fluence. The apparent change between the exposed 1202 and unexposed 1201 SiGe surface roughness is clearly visible. The surface roughness of the exposed poly-SiGe areas 1202 is increased to 174 nm, similar to the value obtained previously for the 1.8 $\mu$m thick sample treated with the same fluence.

Further tests to the Al layer 104 itself showed that the surface roughness experienced almost no change. A blanket 1 $\mu$m Al layer was exposed to a harsh laser fluence of 960 mJ/cm$^2$, to examine the endurance of the layer to higher laser annealing conditions. The surface roughness of the layer started at a value of 30 nm pre-treatment and only increased to 31 nm posttreatment. In fact, to increase the surface roughness to 72 nm, 2400 pulses at the same laser fluence had to be applied. It was only after 6000 pulses that the roughness increased to 221 nm.

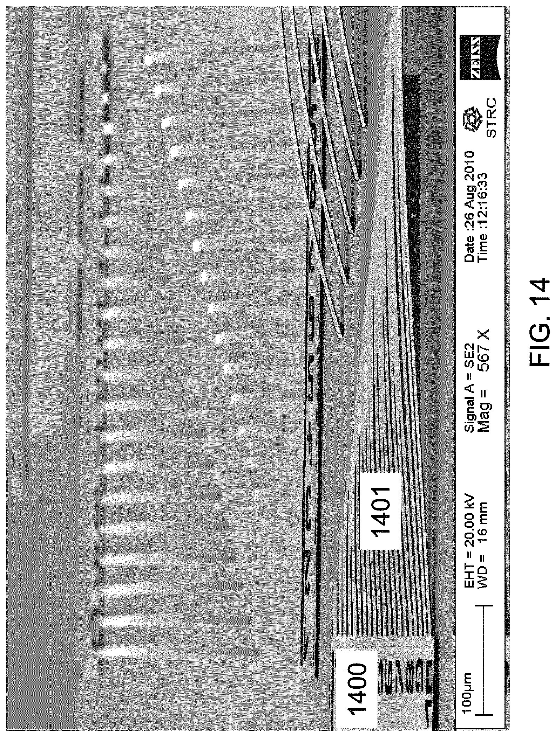

FIG. 14 shows a secondary electron microscopy (SEM) image of a series of cantilevers manufactured according to embodiments of the present invention. The suspended area 1401 was shielded with an aluminum layer when applying a first laser anneal to contact area 1400 of the series of cantilevers. A laser energy of 100mJ was applied and it can be seen that the released cantilevers suffer from strain (bending cantilevers).

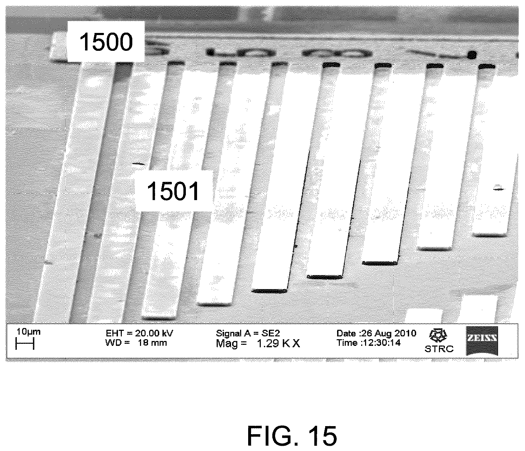

FIG. 15 shows a secondary electron microscopy (SEM) image of a series of cantilevers manufactured according to embodiments of the present invention. The suspended area 1501 was shielded with an aluminum layer when applying a first laser anneal to contact area 1500 of the series of cantilevers. A laser energy of 100mJ was applied. Thereafter the aluminum layer was removed and a second laser anneal was applied to both the contact area 1500 and the suspended area 1501 of the series of cantilevers. The first anneal was a single pulse anneal of 100mJ, whereas the second anneal was a pulsed anneal of 20mJ and 1000 pulses at 20Hz. It can be seen that the released cantilevers do not suffer from strain and are nicely released without any bending.

Embodiments of the present invention demonstrated the possibility to realize semiconductor films, in particular SiGe films, deposited at 210 °C with a low resistivity in the contact areas (down to 3.47 m$\Omega\cdot$cm) and a low strain gradient of $-1.6\times10^{-7}$ $\mu$m$^{-1}$ for the freestanding structures using a 2-step laser annealing process of which 1 step uses a patterned shielding layer, e.g. a patterned Al shielding layer. The A1 shield is highly reflective to the UV radiation and no drastic changes are detected in the shield after laser anneal.

It is to be understood that although preferred embodiments, specific constructions and configurations, as well as materials, have been discussed herein for devices according to the present invention, various changes or modifications in form and detail may be made without departing from the scope of this invention as defined by the appended claims. Functionality may be added or deleted from the block diagrams and operations may be interchanged among functional blocks. Steps may be added or deleted to methods described within the scope of the present invention.

**Claims**

**1.** A method for manufacturing a micromachined device, the method comprising:

- providing a structural layer (101) of amorphous semiconductor material, the structural layer (101) having an initial resistivity and an initial strain gradient;
- defining a first region (111) and a second region (112) in the structural layer (101);
- providing a shielding layer (104) above the first region (111), thereby leaving the second region (112) unshielded;
- thereafter laser annealing the second region (112) of the structural layer (101) with a first fluence, wherein said laser annealing with the first fluence decreases the resistivity in the second region (112) from the initial resistivity to a predetermined resistivity (112), said first fluence being in the range of 600 mJ/cm$^2$ to 1000 mJ/cm$^2$;
- thereafter removing the shielding layer (104);

- thereafter laser annealing the first (111) and the second region (112) of the structural layer (101) with a second fluence, the second fluence being not larger than half of the first fluence, wherein said laser annealing with the second fluence decreases the strain gradient in the first region (111) from the initial strain gradient to a predetermined strain gradient.

2. A method for manufacturing a micromachined device according to claim 1, wherein laser annealing the first region (111) and the second region (112) with the second fluence comprises laser annealing with a fluence smaller than 250mJ/cm$^2$.

3. A method for manufacturing a micromachined device according to any of claims 1 to 2, wherein laser annealing the second region (112) of the structural layer (101) with the first fluence induces a conversion of at least part of the amorphous semiconductor material in the second region (112).

4. A method for manufacturing a micromachined device according to claim 3, wherein converting at least part of the amorphous semiconductor material in the second region (112) may comprise converting completely the amorphous semiconductor material in the second region (112).

5. A method for manufacturing a micromachined device according to any of claims 1 to 4, wherein laser annealing the first region (111) and the second region (112) of the structural layer (101) with the second fluence comprises laser annealing thereby converting at least part of the amorphous semiconductor material in the first region (111).

6. A method for manufacturing a micromachined device according to claim 5, wherein converting at least part of the amorphous semiconductor material in the first region (111) comprises converting at least the upper part of the amorphous semiconductor material in the first region (111).

7. A method for manufacturing a micromachined device according to any of claims 3 to 6, wherein converting at least part of the amorphous semiconductor material comprises converting at least part of the amorphous semiconductor material into crystalline semiconductor material.

8. A method for manufacturing a micromachined device according to any of claims 1 to 7, wherein providing a structural layer (101) of amorphous semiconductor material comprises performing a plasma enhanced chemical vapor deposition (PECVD) process.

9. A method for manufacturing a micromachined device according to any of claims 1 to 8, wherein providing a structural layer (101) of amorphous semiconductor material is performed at temperature below 400 degrees Celsius.

10. A method for manufacturing a micromachined device according to any of claims 1 to 9, wherein defining a first region (111) and a second region (112) in the structural layer (101) comprises defining a suspended region and a contact region, respectively, in the structural layer (101).

11. A method for manufacturing a micromachined device according to any of claims 1 to 10, wherein providing a shielding layer (104) comprises providing a layer comprising a reflective material.

**Patentansprüche**

1. Verfahren zum Herstellen einer mikrobearbeiteten Vorrichtung, wobei das Verfahren umfasst:

- Bereitstellen einer Strukturschicht (101) aus amorphem Halbleitermaterial, wobei die Strukturschicht (101) einen anfänglichen spezifischen Widerstand und einen anfänglichen Dehnungsgradienten aufweist;
- Definieren einer ersten Region (111) und einer zweiten Region (112) in der Strukturschicht (101);
- Bereitstellen einer Abschirmschicht (104) über der ersten Region (111), wodurch die zweite Region (112) ungeschirmt belassen wird;
- danach Laserhärten der zweiten Region (112) der Strukturschicht (101) mit einer ersten Fluenz, wobei das Laserhärten mit der ersten Fluenz den spezifischen Widerstand in der zweiten Region (112) vom anfänglichen spezifischen Widerstand auf einen vorbestimmten spezifischen Widerstand (112) senkt, wobei die erste Fluenz im Bereich von 600 mJ/cm$^2$ bis 1000 mJ/cm$^2$ beträgt;
- danach Entfernen der Abschirmschicht (104);

- danach Laserhärten der ersten (111) und der zweiten Region (112) der Strukturschicht (101) mit einer zweiten Fluenz, wobei die zweite Fluenz nicht mehr als die Hälfte der ersten Fluenz beträgt, wobei das Laserhärten mit der zweiten Fluenz den Dehnungsgradienten in der ersten Region (111) vom anfänglichen Dehnungsgradienten auf einen vorbestimmten Dehnungsgradienten senkt.

2. Verfahren zum Herstellen einer mikrobearbeiteten Vorrichtung nach Anspruch 1, wobei das Laserhärten der ersten Region (111) und der zweiten Region (112) mit der zweiten Fluenz das Laserhärten mit einer Fluenz von weniger als 250 mJ/cm$^2$ umfasst.

3. Verfahren zum Herstellen einer mikrobearbeiteten Vorrichtung nach einem der Ansprüche 1 bis 2, wobei das Laserhärten der zweiten Region (112) der Strukturschicht (101) mit der ersten Fluenz eine Umwandlung von mindestens einem Teil des amorphen Halbleitermaterials in der zweiten Region (112) induziert.

4. Verfahren zum Herstellen einer mikrobearbeiteten Vorrichtung nach Anspruch 3, wobei das Umwandeln von mindestens einem Teil des amorphen Halbleitermaterials in der zweiten Region (112) das vollständige Umwandeln des amorphen Halbleitermaterials in der zweiten Region (112) umfassen kann.

5. Verfahren zum Herstellen einer mikrobearbeiteten Vorrichtung nach einem der Ansprüche 1 bis 4, wobei das Laserhärten der ersten Region (111) und der zweiten Region (112) der Strukturschicht (101) mit der zweiten Fluenz das Laserhärten umfasst, wodurch mindestens ein Teil des amorphen Halbleitermaterials in der ersten Region (111) umgewandelt wird.

6. Verfahren zum Herstellen einer mikrobearbeiteten Vorrichtung nach Anspruch 5, wobei das Umwandeln von mindestens einem Teil des amorphen Halbleitermaterials in der ersten Region (111) das Umwandeln von mindestens dem oberen Teil des amorphen Halbleitermaterials in der ersten Region (111) umfasst.

7. Verfahren zum Herstellen einer mikrobearbeiteten Vorrichtung nach einem der Ansprüche 3 bis 6, wobei das Umwandeln von mindestens einem Teil des amorphen Halbleitermaterials das Umwandeln von mindestens einem Teil des amorphen Halbleitermaterials in kristallines Halbleitermaterial umfasst.

8. Verfahren zum Herstellen einer mikrobearbeiteten Vorrichtung nach einem der Ansprüche 1 bis 7, wobei das Bereitstellen einer Strukturschicht (101) aus amorphem Halbleitermaterial das Durchführen eines plasmaverstärkten chemischen Dampfabscheidungs- (PECVD) Prozesses umfasst.

9. Verfahren zum Herstellen einer mikrobearbeiteten Vorrichtung nach einem der Ansprüche 1 bis 8, wobei das Bereitstellen einer Strukturschicht (101) aus amorphem Halbleitermaterial bei Temperatur unter 400 Grad Celsius durchgeführt wird.

10. Verfahren zum Herstellen einer mikrobearbeiteten Vorrichtung nach einem der Ansprüche 1 bis 9, wobei das Definieren einer ersten Region (111) und einer zweiten Region (112) in der Strukturschicht (101) das Definieren jeweils einer freitragenden Region und einer Kontaktregion in der Strukturschicht (101) umfasst.

11. Verfahren zum Herstellen einer mikrobearbeiteten Vorrichtung nach einem der Ansprüche 1 bis 10, wobei das Bereitstellen einer Abschirmschicht (104) das Bereitstellen einer Schicht umfasst, die ein reflektierendes Material umfasst.

**Revendications**

1. Procédé de fabrication d'un dispositif micro-usiné, le procédé comprenant :

   - la fourniture d'une couche structurale (101) de matériau semi-conducteur amorphe, la couche structurale (101) ayant une résistivité initiale et un gradient de déformation initial ;
   - la définition d'une première région (111) et d'une seconde région (112) dans la couche structurale (101) ;
   - la fourniture d'une couche de blindage (104) au-dessus de la première région (111), laissant ainsi la seconde région (112) non blindée ;
   - puis le recuit laser de la seconde région (112) de la couche structurale (101) avec une première fluence, dans lequel ledit recuit laser avec la première fluence diminue la résistivité dans la seconde région (112) de la résistivité initiale à une résistivité prédéterminée (112), ladite première fluence étant dans la plage de 600 mJ/cm$^2$ à 1 000 mJ/cm$^2$ ;

- puis le retrait de la couche de blindage (104) ;

- puis le recuit laser des première (111) et seconde (112) régions de la couche structurale (101) avec une seconde fluence, la seconde fluence n'étant pas plus grande que la moitié de la première fluence, dans lequel ledit recuit laser avec la seconde fluence diminue le gradient de déformation dans la première région (111) du gradient de déformation initial à un gradient de déformation prédéterminé.

2. Procédé de fabrication d'un dispositif micro-usiné selon la revendication 1, dans lequel le recuit laser de la première région (111) et de la seconde région (112) avec la seconde fluence comprend le recuit laser avec une fluence plus petite que 250 mJ/cm$^2$.

3. Procédé de fabrication d'un dispositif micro-usiné selon l'une quelconque des revendications 1 et 2, dans lequel le recuit laser de la seconde région (112) de la couche structurale (101) avec la première fluence induit une conversion d'au moins une partie du matériau semi-conducteur amorphe dans la seconde région (112).

4. Procédé de fabrication d'un dispositif micro-usiné selon la revendication 3, dans lequel la conversion d'au moins une partie du matériau semi-conducteur amorphe dans la seconde région (112) peut comprendre la conversion complète du matériau semi-conducteur amorphe dans la seconde région (112).

5. Procédé de fabrication d'un dispositif micro-usiné selon l'une quelconque des revendications 1 à 4, dans lequel le recuit laser de la première région (111) et de la seconde région (112) de la couche structurale (101) avec la seconde fluence comprend le recuit laser convertissant ainsi au moins une partie du matériau semi-conducteur amorphe dans la première région (111).

6. Procédé de fabrication d'un dispositif micro-usiné selon la revendication 5, dans lequel la conversion d'au moins une partie du matériau semi-conducteur amorphe dans la première région (111) comprend la conversion d'au moins la partie supérieure du matériau semi-conducteur amorphe dans la première région (111).

7. Procédé de fabrication d'un dispositif micro-usiné selon l'une quelconque des revendications 3 à 6, dans lequel la conversion d'au moins une partie du matériau semi-conducteur amorphe comprend la conversion d'au moins une partie du matériau semi-conducteur amorphe en un matériau semi-conducteur cristallin.

8. Procédé de fabrication d'un dispositif micro-usiné selon l'une quelconque des revendications 1 à 7, dans lequel la fourniture d'une couche structurale (101) de matériau semi-conducteur amorphe comprend la réalisation d'un processus de dépôt chimique en phase vapeur activé par plasma (PECVD).

9. Procédé de fabrication d'un dispositif micro-usiné selon l'une quelconque des revendications 1 à 8, dans lequel la fourniture d'une couche structurale (101) de matériau semi-conducteur amorphe est réalisée à une température en dessous de 400 degrés Celsius.

10. Procédé de fabrication d'un dispositif micro-usiné selon l'une quelconque des revendications 1 à 9, dans lequel la définition d'une première région (111) et d'une seconde région (112) dans la couche structurale (101) comprend la définition d'une région interrompue et d'une région de contact, respectivement, dans la couche structurale (101).

11. Procédé de fabrication d'un dispositif micro-usiné selon l'une quelconque des revendications 1 à 10, dans lequel la fourniture d'une couche de blindage (104) comprend la fourniture d'une couche comprenant un matériau réfléchissant.

FIG. 1

FIG. 2

FIG. 3

EP 2 347 993 B1

114

111 112

101

105

102

103

100

FIG. 4

FIG. 5

FIG. 6

FIG. 8

**Poly-SiGe**

902

SiGe                                901

Si                                  904

oxide                               903

Si substrate                        905

1 µm

FIG. 9

EP 2 347 993 B1

FIG. 10

FIG. 11

EP 2 347 993 B1

a-SiGe 1201

Poly-SiGe 1202

| 20µm | EHT = 8.00 kV | Signal A = InLens | Date :9 Jul 2009 | |
|---|---|---|---|---|
| | WD = 9 mm | Mag = 1.24 K X | Time :10:18:04 | STRC |

FIG. 12

FIG. 13

FIG. 15

**EP 2 347 993 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1801067 A2